# EUROPEAN PATENT APPLICATION

(11) **EP 4 753 099 A1**
(43) Date of publication of application: **03.06.2026**
(21) Application number: 24883929.2
(22) Date of filing: 12.06.2024
(51) Int. Cl.: H02J 7/00, H02M 1/44

(54) **BATTERY MANAGEMENT SYSTEM AND ELECTRIC DEVICE**

(30) Priority: 03.11.2023 CN 202322979832 U
(71) Applicant: Contemporary Amperex Technology Co., Limited, Ningde, Fujian 352100 (CN); Contemporary Amperex Runzhi Software Technology Limited, Ningde, Fujian 352100 (CN)
(72) Inventor: WU, Kai, Ningde, Fujian 352100 (CN); XIA, Zhangle, Ningde, Fujian 352100 (CN); LI, Weiqiang, Ningde, Fujian 352100 (CN); LUO, Huixiu, Ningde, Fujian 352100 (CN)
(74) Representative: Kraus & Lederer PartGmbB
(86) International application number: PCT/CN2024/098651
(87) International publication number: WO 2025/091918

(57) **Abstract**

The present application discloses a battery management system and an electric device. The battery management system comprises a first circuit and a protection circuit, wherein the first circuit is connected to the protection circuit, and the protection circuit is used for reducing the amplitude of an interference signal entering the first circuit. The embodiments of the present application can improve the reliability of the battery management system.

## Description

### CROSS-REFERENCE TO RELATED APPLICATIONS

The present application claims priority to Chinese Patent Application No. 202322979832.X, filed on November 03, 2023 and entitled "Battery Management System and Electric device", which is incorporated herein by reference in its entirety.

### TECHNICAL FIELD

The present application relates to the technical field of battery management, and in particular, to a battery management system and an electric device.

### BACKGROUND

With the rapid development of social economy and the continuous progress of automobile technology, the number of automobiles is increasing nowadays, and automobiles have gradually become indispensable transportation tools in people's daily lives. A battery of an electric device, as a power supply, can supply power to an electric module on an automobile and is an indispensable component in the automobile.

A battery management system (BMS) may be used to manage a battery.

However, there is a problem in the related art that the reliability of the battery management system is not high.

### SUMMARY

The present application provides a battery management system and an electric device, which can improve the reliability of the battery management system.

In a first aspect, the present application provides a battery management system, comprising a first circuit and a protection circuit, wherein the first circuit is connected to the protection circuit, and the protection circuit is used for reducing the amplitude of an interference signal entering the first circuit.

In an embodiment of the present application, since the protection circuit is provided and may be used for reducing the amplitude of an interference signal entering the first circuit, the interference intensity of the interference signal accessing the first circuit may be reduced so as to reduce the possibility that an error frame is generated in the communication of the first circuit and help avoid the occurrence of an extreme case of damaging the first circuit, thereby helping improve the reliability of the battery management system.

In one possible implementation of the first aspect, the first circuit is connected to a first reference ground, the first reference ground is connected to a second reference ground, one end of a first capacitor is connected to the second reference ground, and the other end of the first capacitor is connected to a negative electrode of a battery through a switch module.

The protection circuit comprises a first protection circuit which is connected between the first reference ground and the second reference ground and used for reducing the amplitude of an interference signal entering the first circuit from the first capacitor.

In an embodiment of the present application, the first reference ground is no longer directly connected to the second reference ground, but the first protection circuit is provided between the first reference ground and the second reference ground. Since the first protection circuit may be used for reducing the amplitude of an interference signal entering the first circuit from the first capacitor, the interference intensity of an interference signal received by the first circuit from the first capacitor may be reduced so as to reduce the possibility that an error frame is generated in the communication of the first circuit and help avoid the occurrence of an extreme case of damaging the first circuit, thereby helping improve the reliability of the battery management system.

In one possible implementation of the first aspect, the first protection circuit comprises a first branch which is connected between the first reference ground and the second reference ground and used for reducing the amplitude of an alternating-current interference signal entering the first circuit.

An interference signal may comprise an alternating-current signal. In an embodiment of the present application, by providing the first branch, the interference of an alternating-current interference signal received by the first circuit from the first capacitor may be reduced.

In one possible implementation of the first aspect, the first branch comprises a first resistor and a second capacitor, and the first resistor and the second capacitor are connected in series. The amplitude of the alternating-current interference signal accessing the first circuit may be reduced through a combination of the first resistor and the second capacitor.

In one possible implementation of the first aspect, the first protection circuit further comprises a second branch which is connected in parallel with the first branch and used for reducing the amplitude of a direct-current interference signal entering the first circuit.

An interference signal may comprise a direct-current signal. In an embodiment of the present application, by providing the second branch, the interference of a direct-current interference signal on the first circuit may be reduced.

In one possible implementation of the first aspect, the second branch comprises a second resistor.

An interference signal may comprise a direct-current signal. By providing the second resistor, the amplitude of the direct-current interference signal accessing the first circuit may be reduced.

In one possible implementation of the first aspect, the battery management system further comprises a second circuit which is connected to a battery through a communication line.

The protection circuit comprises a second protection circuit which is connected between the first circuit and the second circuit and used for reducing the amplitude of an interference signal entering the first circuit from the second circuit.

In an embodiment of the present application, the second protection circuit is provided between the second circuit and the first circuit. Since the second protection circuit may be used for reducing the amplitude of an interference signal entering the first circuit from the second circuit, the interference intensity of an interference signal received by the first circuit from the second circuit may be reduced so as to reduce the possibility that an error frame is generated in the communication of the first circuit and help avoid the occurrence of an extreme case of damaging the first circuit, thereby helping improve the reliability of the battery management system.

In one possible implementation of the first aspect, the second protection circuit comprises a third branch which is used for reducing the amplitude of an alternating-current interference signal entering the first circuit.

An interference signal transmitted from the second circuit to the first circuit is usually an alternating-current signal. In an embodiment of the present application, by providing the third branch, the interference of an alternating-current interference signal received by the first circuit from the second circuit may be reduced.

In one possible implementation of the first aspect, the third branch comprises a third resistor and a third capacitor, and the third resistor and the third capacitor are connected in series.

An interference signal may comprise an alternating-current signal, and a capacitor may be used to allow an alternating-current to pass through and block a direct-current. The amplitude of an alternating-current interference signal accessing the first circuit may be reduced through a combination of the third resistor and the third capacitor.

Based on the same application concept, in a second aspect, an embodiment of the present application provides an electric device, comprising a battery and the battery management system according to any one embodiment of the first aspect.

The above description is merely an overview of the technical solutions of the present application. For a clearer understanding of the technical means of the present application, the present application can be carried out in accordance with the content of the description, and in order to make the above and other objectives, characteristics, and advantages of the present application apparent and comprehensible, specific embodiments of the present application are described below.

### BRIEF DESCRIPTION OF THE DRAWINGS

The feature, advantage, and technical effect of the exemplary embodiment of the present application is described below with reference to the figures.
FIG. 1 is a schematic structural diagram of a battery management system according to one embodiment of the present application;
FIG. 2 is a schematic structural diagram of a battery management system according to another embodiment of the present application;
FIG. 3 shows a comparative example of FIG. 2;
FIG. 4 is a schematic structural diagram of a battery management system according to yet another embodiment of the present application;
FIG. 5 is a schematic structural diagram of a battery management system according to yet another embodiment of the present application;
FIG. 6 is a schematic structural diagram of a battery management system according to yet another embodiment of the present application;
FIG. 7 is a schematic structural diagram of a battery management system according to yet another embodiment of the present application; and
FIG. 8 is a schematic diagram of a module structure of an electric device according to one embodiment of the present application.

The figures are not necessarily drawn to the actual scale.

In the figures:
10: battery management system;
11: first circuit;
12: protection circuit;
121: first protection circuit; 1211: first branch; 1212: second branch;
122: second protection circuit; 1223: third branch;
131: first switch module; 132: second switch module;
141: housing; 142: entire vehicle body;
15: second circuit;
161: first communication line; 162: second communication line; 163: third communication line;
100: electric device.

### DETAILED DESCRIPTION OF PREFERRED EMBODIMENTS

To make the objectives, technical solutions, and advantages of the embodiments of this application clearer, the following clearly and completely describes the technical solutions in the embodiments of this application with reference to the accompanying drawings in the embodiments of this application. Apparently, the described embodiments are some but not all of the embodiments of this application. All other embodiments obtained by a person of ordinary skill in the art based on the embodiments of the present application without making creative efforts shall fall within the protection scope of the present application.

Unless otherwise defined, all technical and scientific terms used in the present application have the same meaning as commonly understood by a person skilled in the art of the present application. In the present application, the terms used in the description of the present application are only used for describing specific embodiments and are not intended to limit the present application, and the terms "comprise", "have", and any variations thereof in the description and claims of the present application and the above description of the drawings are intended to cover a non-exclusive inclusion.

The terms "first", "second", and the like in the description and claims of the present application or in the drawings are used to distinguish between different objects, and are not used to describe a specific sequence or a primary-secondary relationship.

In the description of the embodiments of the present application, the term "and/or" merely describes an association relationship of associated objects, indicating that three relationships may exist, for example, A and/or B may mean that A exists alone, A and B exist simultaneously, or B exists alone. In addition, the character "/" herein generally indicates that associated objects are in a "or" relationship.

In the description of the present application, it should be noted that, unless explicitly specified and defined otherwise, the terms "mount", "couple", "connect", and "attach" are to be understood in a broad sense. For example, the terms may indicate a fixed connection, a detachable connection, or an integral connection, and may indicate a direct connection or an indirect connection implemented via an intermediate medium, or internal communication between two elements. A person skilled in the art can understand specific meanings of these terms in the present application according to specific situations.

A battery management system may comprise a first circuit, which is, for example, some low-voltage circuits of the battery management system. The voltage of a low-voltage circuit is relatively low. In some cases, the first circuit may be accessed by an interference signal. The applicant has found through research that if the amplitude of the interference signal is excessively large, it will cause the communication of the first circuit to generate an error frame, and will even damage the first circuit in an extreme case, resulting in a problem that the reliability of the battery management system is not high.

In order to solve the above technical problem, the embodiments of the present application provide a battery management system and an electric device. The battery management system and the electric device provided in the embodiments of the present application will be introduced in detail below with reference to the accompanying drawings.

The battery management system provided in the embodiments of the present application is first introduced below.

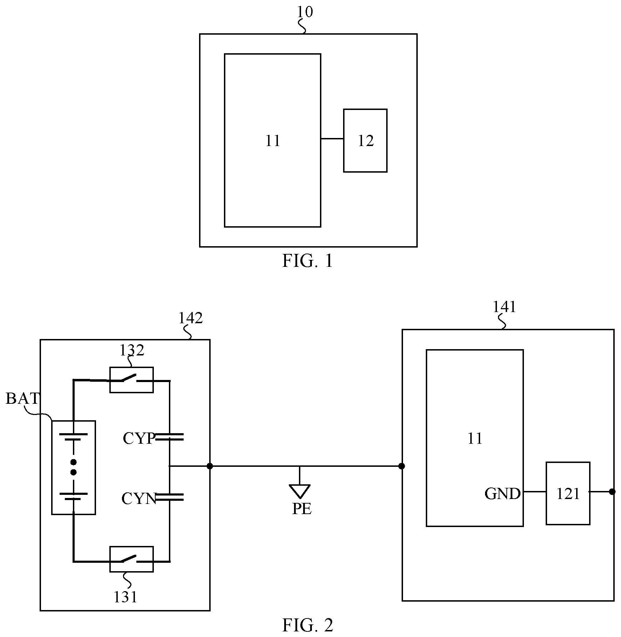

FIG. 1 is a schematic structural diagram of a power supply control circuit according to one embodiment of the present application. As shown in FIG. 1, the battery management system 10 may comprise a first circuit 11 and a protection circuit 12.

The first circuit 11 is connected to the protection circuit 12, and the protection circuit 12 may be used for reducing the amplitude of an interference signal entering the first circuit 11.

In an embodiment of the present application, since the protection circuit 12 is provided and may be used for reducing the amplitude of an interference signal entering the first circuit 11, the interference intensity of an interference signal accessing the first circuit 11 may be reduced so as to reduce the possibility that an error frame is generated in the communication of the first circuit 11 and help avoid the occurrence of an extreme case of damaging the first circuit, thereby helping improve the reliability of the battery management system.

Exemplarily, the battery management system 10 may be disposed on a circuit board, and the circuit board may comprise a low-voltage region and a high-voltage region. The low-voltage region may be used to set the first circuit 11 of the battery management system 10, and the high-voltage region may be used to set a second circuit 15 of the battery management system 10 (the second circuit will be introduced below).

It should be noted that the voltage of the high-voltage region is greater than the voltage of the low-voltage region, the operating voltage of the first circuit 11 is less than the operating voltage of the second circuit, the magnitudes of the voltages of the high-voltage region and the low-voltage region are relative, and the operating voltage of the first circuit 11 and the operating voltage of the second circuit are also relative. The present application does not limit the specific values or ranges of the voltages of the high-voltage region and the low-voltage region, nor does it limit the specific values or ranges of the operating voltage of the first circuit 11 and the operating voltage of the second circuit.

Exemplarily, the first circuit 11 may comprise, but is not limited to, a power circuit module, a control module, a storage module, and the like. The power circuit module may supply power to an electric device of the battery management system 10. The control module may be used to control turn-off of a switch device, signal processing, and the like. The storage module may be used to store a signal.

Exemplarily, the power circuit module may comprise, but is not limited to, a DCDC converter.

Exemplarily, the control module may be a chip or a circuit that performs a related action according to a characteristic instruction. For example, the control module may be a microcontroller unit (MCU), or may be a digital signal processor (DSP), an application specific-integrated circuit (ASIC), a field-programmable gate array (FPGA), or other programmable logic devices, a discrete gate or transistor logic device, a discrete hardware component, or the like. For another example, the control module may comprise an external clock, a random access memory (RAM), a read-only memory (ROM), and the like.

It should be noted that the functional modules included in the first circuit 11 and the introduction of the functions and structures of the functional modules in the above examples are merely exemplary, and the present application does not limit the specific structure of the first circuit 11.

The present application does not limit the specific structure of the protection circuit 12, as long as the protection circuit 12 can reduce the amplitude of an interference signal entering the first circuit 11. Some examples of the protection circuit 12 will be introduced below.

In some embodiments, as shown in FIG. 2, the first circuit 11 is connected to a first reference ground GND, and the first reference ground GND is connected to a second reference ground PE. There are equivalent capacitors between positive and negative electrodes of a battery BAT and the second reference ground PE, respectively. Hereinafter, the equivalent capacitor between the negative electrode of the battery BAT and the second reference ground PE is referred to as a first capacitor CYN, and the equivalent capacitor between the positive electrode of the battery BAT and the second reference ground PE is referred to as a second Y capacitor CYP. In addition, the positive electrode and the negative electrode of the battery BAT may be respectively connected to switch modules. Hereinafter, the switch module to which the negative electrode of the battery BAT is connected is referred to as a first switch module 131, and the switch module to which the positive electrode of the battery BAT is connected is referred to as a second switch module 132.

One end of the first capacitor CYN is connected to the second reference ground PE, and the other end of the first capacitor CYN is connected to the negative electrode of the battery BAT through the first switch module 131. One end of the second Y capacitor CYP is connected to the second reference ground PE, and the other end of the second Y capacitor CYP is connected to the positive electrode of the battery BAT through the second switch module 132.

The protection circuit may comprise a first protection circuit 121 which is connected between the first reference ground GND and the second reference ground PE and may be used for reducing the amplitude of an interference signal entering the first circuit 11 from the first capacitor CYN.

The first reference ground GND may be understood as a low-voltage reference ground, and the second reference ground PE may be understood as a high-voltage reference ground. The absolute value of the voltage of the first reference ground GND may be smaller than the absolute value of the voltage of the second reference ground PE.

Exemplarily, the battery management system may comprise a battery management unit (BMU) which comprises a housing 141. The first circuit 11 is connected to the first reference ground GND, and the first reference ground GND is connected to the housing 141.

Exemplarily, the battery BAT and the battery management system may be used in an electric device, and the electric device may comprise an electric device. The second reference ground PE may be connected to an entire vehicle body 142 of the electric device.

Exemplarily, the housing 141 may be fixed to the entire vehicle body 142 by bolts or other connection methods.

Exemplarily, the first switch module 131 and the second switch module 132 may perform a turn-on or turn-off action. The first switch module 131 and the second switch module 132 may comprise switches such as relays.

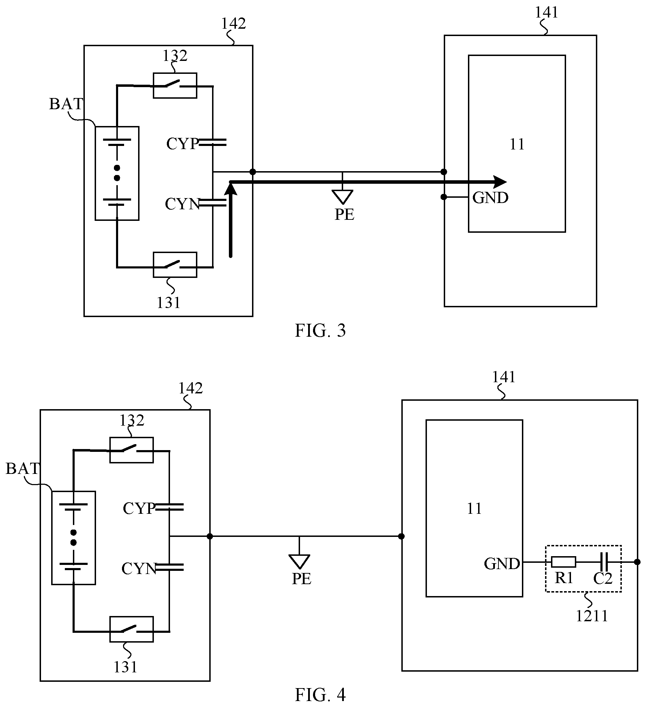

As a comparison, please refer to FIG. 3. The similarities between FIG. 3 and FIG.2 are not repeated, and the differences comprise: the first protection circuit is not provided in FIG. 3, and the first reference ground GND is directly connected to the second reference ground PE. Due to the existence of the first capacitor CYN, when the first switch module 131 is closed, a highfrequency interference signal generated by the closing of the first switch module 131 will be transmitted to the first reference ground GND and the first circuit 11 through the first capacitor CYN. Due to the lack of preventive measures, the interference signal entering the first reference ground GND and the first circuit 11 is almost not attenuated, which easily causes an error frame to be generated on a communication line to which the first reference ground GND is connected, and can damage the circuit board in an extreme case. Here, a path through which the interference signal passes is represented by a thick solid line with an arrow in FIG. 3.

However, in an embodiment of the present application, the first reference ground GND is no longer directly connected to the second reference ground PE, but the first protection circuit 121 is provided between the first reference ground GND and the second reference ground PE. Since the first protection circuit 121 may be used for reducing the amplitude of an interference signal entering the first circuit 11 from the first capacitor CYN, the interference intensity of an interference signal received by the first circuit 11 from the first capacitor CYN may be reduced so as to reduce the possibility that an error frame is generated in the communication of the first circuit 11 and help avoid the occurrence of an extreme case of damaging the first circuit, thereby helping improve the reliability of the battery management system.

In some embodiments, as shown in FIG. 4, the first protection circuit may comprise a first branch 1211 which is connected between the first reference ground GND and the second reference ground PE and used for reducing the amplitude of an alternating-current interference signal entering the first circuit 11.

An interference signal may comprise an alternating-current signal. In an embodiment of the present application, by providing the first branch 1211, the interference of an alternating-current interference signal received by the first circuit 11 from the first Y capacitor CYN may be reduced.

On a signal transmission path, the larger the impedance is, the lower the amplitude of the accessed signal will be. As an example, the first branch 1211 may be used to increase the impedance between the first reference ground GND and the second reference ground PE.

It should be noted that the first branch 1211 being used to increase the impedance is relative to a direct connection between the first reference ground GND and the second reference ground PE. In the case where the first reference ground GND is directly connected to the second reference ground PE, the impedance between the first reference ground GND and the second reference ground PE is low. However, in an embodiment of the present application, the first reference ground GND is connected to the second reference ground PE through the first branch 1211, and the first branch 1211 may increase the impedance.

For example, an impedance value of the first branch 1211 may be a fixed value. For another example, the impedance value of the first branch 1211 may also change as the scenario changes. For example, the impedance value of the first branch 1211 may increase as the amplitude of the interference signal increases.

In some embodiments, as shown in FIG. 4, the first branch 1211 may comprise a first resistor R1 and a second capacitor C2, and the first resistor R1 and the second capacitor C2 are connected in series.

The larger a resistance value of the first resistor R1 is, the larger the impedance of the first branch 1211 is. An interference signal may comprise an alternating-current signal, and a capacitor may be used to allow an alternating-current to pass through and block a direct-current. The amplitude of an alternating-current interference signal accessing the first circuit 11 may be reduced through a combination of the first resistor R1 and the second capacitor C2.

The resistance value of the first resistor R1 and a capacitance value of the second capacitor C2 may be set according to actual requirements. For example, the resistance value of the first resistor R1 is 1M ohm, and the capacitance value of the second capacitor C2 is 10 uF. It should be noted that the specific parameters of elements mentioned in this embodiment and other embodiments are only some examples, and the specific parameters of elements in the present application may comprise, but are not limited to these.

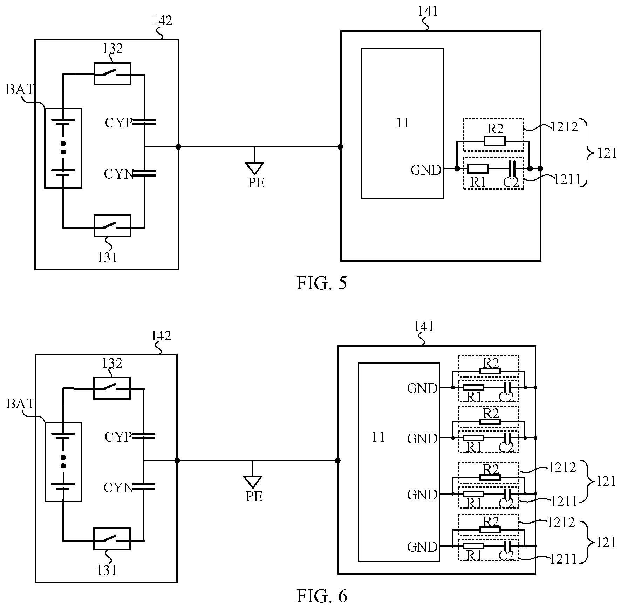

In some embodiments, as shown in FIG. 5, the first protection circuit 121 may further comprise a second branch 1212 which is connected in parallel with the first branch 1211. The second branch 1212 may be used for reducing the amplitude of a direct-current interference signal entering the first circuit 11.

An interference signal may comprise a direct-current signal. In an embodiment of the present application, by providing the second branch 1212, the interference of a direct-current interference signal on the first circuit 11 may be reduced.

It may be understood that the first protection circuit 121 comprises the first branch 1211 and the second branch 1222 connected in parallel, so that the first protection circuit 121 can reduce the amplitude of the interference signal entering the first circuit 11 regardless of whether the interference signal is an alternating-current signal or a direct-current signal.

As introduced above, on the signal transmission path, the larger the impedance is, the lower the amplitude of the accessed signal will be. As an example, the second branch 1212 may also be used to increase the impedance between the first reference ground GND and the second reference ground PE.

It should be noted that the second branch 1212 being used to increase the impedance is also relative to a direct connection between the first reference ground GND and the second reference ground PE. In the case where the first reference ground GND is directly connected to the second reference ground PE, the impedance between the first reference ground GND and the second reference ground PE is low. However, in an embodiment of the present application, the first reference ground GND is connected to the second reference ground PE through the second branch 1212, and the second branch 1212 may increase the impedance.

For example, an impedance value of the second branch 1212 may be a fixed value. For another example, the impedance value of the second branch 1212 may also change as the scenario changes. For example, the impedance value of the second branch 1212 may increase as the amplitude of the interference signal increases.

In some embodiments, as shown in FIG. 5, the second branch 1212 may comprise a second resistor R2.

The larger a resistance value of the second resistor R2 is, the larger the impedance of the second branch 1212 is. The interference signal may comprise a direct-current signal. By providing the second resistor R2, the amplitude of a direct-current interference signal accessing the first circuit 11 may be reduced.

The resistance value of the second resistor R2 may be set according to actual requirements. For example, the resistance value of the second resistor R2 is 1M ohm.

Exemplarily, as shown in FIG. 6, the first circuit 11 may be connected to a plurality of first reference grounds GNDs which are connected to the housing 141. There may be provided a plurality of first protection circuits 121, and the plurality of first reference grounds GNDs are connected to the second reference ground PE through the plurality of first protection circuits 121 one by one.

Exemplarily, each first protection circuit 121 may comprise the first branch 1211 and the second branch 1212 connected in parallel. The resistance values of the first resistors R1 in different first branches 1211 may be the same, and the capacitance values of the second capacitors C2 in different first branches 1211 may be the same. The resistance values of the second resistors R2 in different second branches 1212 may be the same.

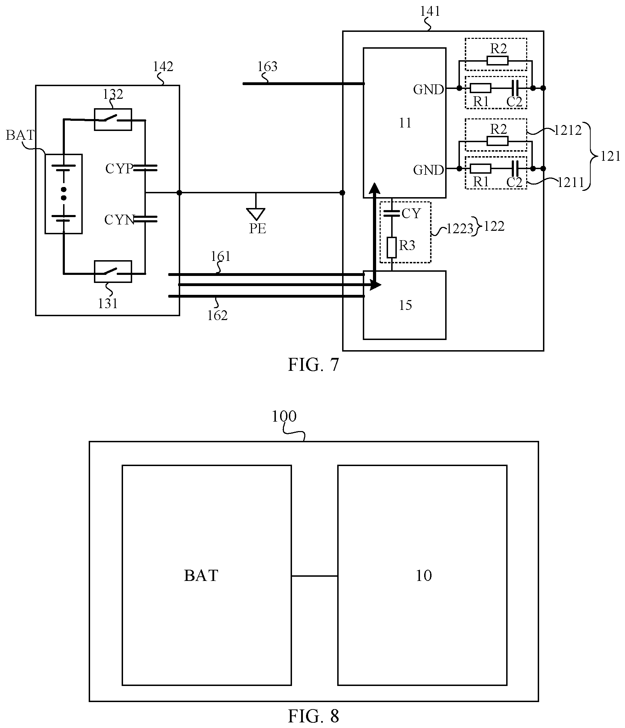

In some embodiments, as shown in FIG. 7, the battery management system may further comprise a second circuit 15 which is connected to the battery BAT through a communication line. The second circuit 15 may be used to acquire a signal. The second circuit 15 may transmit the acquired signal to the first circuit 11, and the first circuit 11 may analyze and process the signal acquired by the second circuit 15.

The protection circuit further comprises a second protection circuit 122 which is connected between the first circuit 11 and the second circuit 15 and may be used for reducing the amplitude of an interference signal entering the first circuit 11 from the second circuit 15.

In FIG. 7, a path of the interference signal is represented by a thick solid line with an arrow. The interference signal may reach the second circuit 15 through a first communication line and/or a second communication line and then reach the first circuit 11. If there are no protective measures for the interference signal on this path, it will cause the amplitude of the interference signal received by the first circuit 11 through this path to be large, and also easily cause the communication of a module in the first circuit 11 to generate an error frame, and will even damage the circuit board in an extreme case.

However, in an embodiment of the present application, the second protection circuit 122 is provided between the second circuit 15 and the first circuit 11. Since the second protection circuit 122 may be used for reducing the amplitude of an interference signal entering the first circuit 11 from the second circuit 15, the interference intensity of an interference signal received by the first circuit 11 from the second circuit 15 may be reduced so as to reduce the possibility that an error frame is generated in the communication of the first circuit 11 and help avoid the occurrence of an extreme case of damaging the first circuit, thereby helping improve the reliability of the battery management system.

Exemplarily, the communication line may comprise a first communication line 161 and a second communication line 162. The first communication line may comprise a daisy chain wire harness. The second communication line 162 may comprise a high-voltage wire harness.

Exemplarily, the second circuit 15 may comprise, but is not limited to, a voltage acquisition module, a current acquisition module, an insulation detection module, and the like. The voltage acquisition module may be used to acquire the voltage of a single battery, the total voltage of the battery, and the like. The current acquisition module may be used to acquire the current of the battery and the like. The insulation detection module may be used to detect the insulation resistance of the battery.

Exemplarily, the voltage acquisition module may comprise, but is not limited to, a sampling resistor, a switch device, and an analog-to-digital converter. The current acquisition module may comprise, but is not limited to, a current sensor. The insulation detection module may be, but is not limited to, a sampling resistor, a switch device, an operational amplifier, etc.

In some embodiments, as shown in FIG. 7, the second protection circuit 122 may comprise a third branch 1223 which may be used for reducing the amplitude of an alternating-current interference signal entering the first circuit 11.

An interference signal transmitted from the second circuit 15 to the first circuit 11 is usually an alternating-current signal. In an embodiment of the present application, by providing the third branch 1223, the interference of an alternating-current interference signal received by the first circuit 11 from the second circuit 15 may be reduced.

As introduced above, on the signal transmission path, the larger the impedance is, the lower the amplitude of the accessed signal will be. As an example, the third branch 1223 may be used to increase the impedance between the first circuit 11 and the second circuit 15.

It should be noted that the third branch 1223 being used to increase the impedance is relative to the first circuit 11 and the second circuit 15 being directly connected in a manner with almost no impedance. In the case where the first circuit 11 and the second circuit 15 are directly connected in a manner with almost no impedance, the impedance between the first circuit 11 and the second circuit 15 is almost negligible. However, in an embodiment of the present application, the first circuit 11 is connected to the second circuit 15 through the third branch 1223, and the third branch 1223 may increase the impedance.

For example, an impedance value of the third branch 1223 may be a fixed value. For another example, the impedance value of the third branch 1223 may also change as the scenario changes. For example, the impedance value of the third branch 1223 may increase as the amplitude of the interference signal increases.

In some embodiments, as shown in FIG. 7, the third branch 1223 may comprise a third resistor R3 and a third capacitor CY, and the third resistor R3 and the third capacitor CY are connected in series.

The third capacitor CY is an isolation capacitor between the second circuit 15 and the first circuit 11.

The larger a resistance value of the third resistor R3 is, the larger the impedance of the third branch 1223 is. An interference signal may comprise an alternating-current signal, and a capacitor may be used to allow an alternating-current to pass through and block a direct-current. The amplitude of an alternating-current interference signal accessing the first circuit 11 may be reduced through a combination of the third resistor R3 and the third capacitor CY.

Similarly, the resistance value of the third resistor R3 and a capacitance value of the third capacitor CY may be set according to actual requirements, which is not limited by the present application.

Exemplarily, as shown in FIG. 7, the battery management system may further comprise a third communication line 163. The third communication line 163 is connected to the first circuit 11, and at least a part of the interference signal received by the first circuit 11 may be released through the third communication line 163. The third communication line 163 may comprise a low-voltage wire harness.

It should be noted that the first reference ground and the second reference ground in the embodiments of the present application may be relative, and the absolute value of the voltage of the first reference ground is less than the absolute value of the voltage of the second reference ground. The first circuit and the second circuit in the embodiments of the present application may also be relative, and the voltage of the first circuit may be less than the voltage of the second circuit.

It should also be noted that alternative solutions based on reducing the amplitude of the interference signal by increasing the impedance of the protection circuit are all within the scope of protection of the present application.

Based on the same application concept, the present application further provides an electric device. As shown in FIG. 8, an electric device 100 comprises a battery BAT and a battery management system 10. The battery management system 10 is the battery management system 10 in any one of the above embodiments. It can be understood that the electric device has the beneficial effects of the battery management system provided in the embodiments of the present application, and for details, reference can be made to the specific description of the battery management system in the above embodiments, which will not be repeated in this embodiment.

It should be noted that, in the embodiments shown in the above figures, the resistor is expressed as an individual resistor, and the capacitor is expressed as a single capacitor. In other embodiments, the resistor may also be an integration of resistors connected in series, in parallel, or in series and parallel, and the capacitor may also be an integration of capacitors connected in series, in parallel, or in series and parallel. Specific parameters of each device may be set according to actual requirements, which is not limited in the present application.

It should be noted that, without contradictory, the embodiments in the present application may be combined with the features in the embodiments.

Although this application has been described with reference to some preferred embodiments, various modifications to this application and replacements of the components therein with equivalents can be made without departing from the scope of this application. In particular, the technical features mentioned in the embodiments may be combined in any manner provided that there is no structural conflict. The present application is not limited to the specific embodiments disclosed herein, but includes all technical solutions falling within the scope of the claims.

## Claims

1. A battery management system, comprising a first circuit and a protection circuit,
wherein the first circuit is connected to the protection circuit, and the protection circuit is used for reducing the amplitude of an interference signal entering the first circuit.

2. The battery management system according to claim 1, wherein the first circuit is connected to a first reference ground, the first reference ground is connected to a second reference ground, one end of a first capacitor is connected to the second reference ground, and the other end of the first capacitor is connected to a negative electrode of a battery through a switch module; and
the protection circuit comprises a first protection circuit which is connected between the first reference ground and the second reference ground and used for reducing the amplitude of an interference signal entering the first circuit from the first capacitor.

3. The battery management system according to claim 2, wherein the first protection circuit comprises a first branch which is connected between the first reference ground and the second reference ground and used for reducing the amplitude of an alternating-current interference signal entering the first circuit.

4. The battery management system according to claim 3, wherein
the first branch comprises a first resistor and a second capacitor, and the first resistor and the second capacitor are connected in series.

5. The battery management system according to claim 3, wherein
the first protection circuit further comprises a second branch which is connected in parallel with the first branch and used for reducing the amplitude of a direct-current interference signal entering the first circuit.

6. The battery management system according to claim 5, wherein
the second branch comprises a second resistor.

7. The battery management system according to any one of claims 1-6, wherein the battery management system further comprises a second circuit which is connected to the battery through a communication line; and
the protection circuit comprises a second protection circuit which is connected between the first circuit and the second circuit and used for reducing the amplitude of an interference signal entering the first circuit from the second circuit.

8. The battery management system according to claim 7, wherein the second protection circuit comprises a third branch which is used for reducing the amplitude of an alternating-current interference signal entering the first circuit.

9. The battery management system according to claim 8, wherein the third branch comprises a third resistor and a third capacitor, and the third resistor and the third capacitor are connected in series.

10. An electric device, comprising:
a battery; and
the battery management system according to any one of claims 1-9.
